# EUROPEAN PATENT SPECIFICATION

(11) **EP 3 304 584 B1**
(45) Date of publication and mention of the grant of the patent: **04.12.2019**
(21) Application number: 16731711.4
(22) Date of filing: 06.06.2016
(51) Int. Cl.: H01J 37/32, H01L 21/67

(54) **HIGH THERMAL CONDUCTIVITY WAFER SUPPORT PEDESTAL DEVICE**
WAFERTRÄGERSOCKELVORRICHTUNG MIT HOHER WÄRMELEITFÄHIGKEIT
DISPOSITIF DE SOCLE DE SUPPORT DE PLAQUETTE DE GRANDE CONDUCTIVITÉ THERMIQUE

(30) Priority: 05.06.2015 US 201562171539 P
(43) Date of publication of application: 11.04.2018
(73) Proprietor: Watlow Electric Manufacturing Company, St. Louis, MO 63146 (US)
(72) Inventor: ATLAS, Boris, Sanjose, CA 95132 (US); NOSRATI, Mohammad, Redwood City, CA 94065 (US); SMITH, Kevin, R., Columbia, MO 65203 (US); AMES, Ken, San Jose, CA 95123 (US); PTASIENSKI, Kevin, O'Fallon, MO 63368 (US)
(74) Representative: Delorme, Nicolas
(86) International application number: PCT/US2016/035970
(87) International publication number: WO 2016/197083

(56) References cited:
- US-A1- 2003 159 307
- US-A1- 2004 212 947
- US-A1- 2013 284 374

## Description

### FIELD

The present disclosure relates to wafer support devices in semiconductor manufacturing tools, and more particularly, to wafer support pedestals of the wafer support devices.

### BACKGROUND

The statements in this section merely provide background information related to the present disclosure and may not constitute prior art.

An electrostatic chuck (ESC) is a wafer support device used in semiconductor manufacturing tools such as plasma etchers and plasma enhanced deposition tools. In particular, the ESC can hold a semiconductor wafer in a pressure controlled processing chamber. The wafer, ESC and process chamber can become a thermodynamic system where excess energy of the process is removed through components such as the ESC assembly. In particular, the ESC assembly can control and maintain temperature of the wafer during processing, for example, by using a liquid coolant circulated through internal channels in a chuck base to cool the wafer.

The ESC assembly can include various components or layers such as an ESC (support substrate), substrate, heater, and cooling plate. The layers can be formed into a stack, and neighboring layers can be bonded together with a thermally conductive elastomer adhesive.

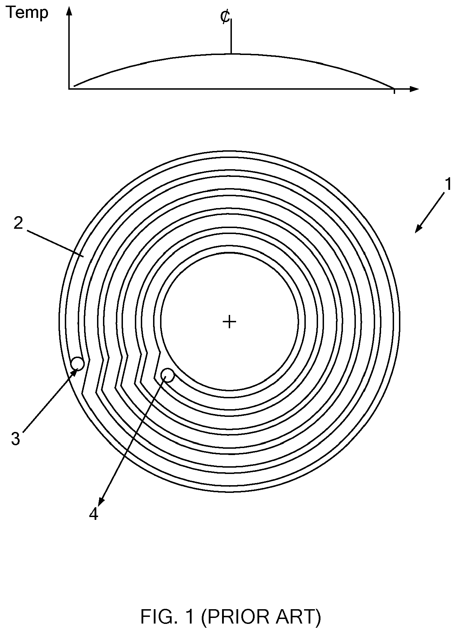

As shown in FIG. 1, a typical wafer support device generally includes a cooling plate 1 defining a spiral cooling channel 2 to circulate a cooling fluid throughout. The spiral cooling channel 2 includes an inlet 3 at a peripheral portion and an outlet 4 adjacent to a central portion of the cooling plate 1. The cooling fluid first circulates along the peripheral portion and then gradually circulates toward the central portion of the cooling plate 1. In the typical ESC assembly with the spiral cooling path, however, the flow path from the inlet 3 to the outlet 4 is relatively long. Moreover, the temperature of the cooling fluid is always higher adjacent to the central portion and lower adjacent to the peripheral portion of the cooling plate 1. Therefore, the typical ESC assembly lacks in providing uniform and rapid cooling for the wafer supported thereon.

### SUMMARY

In one form of the present disclosure, a support pedestal device for an electrostatic chuck of semiconductor manufacturing tools is provided. The support pedestal device includes a base housing defining an internal cavity, a base insert disposed within the internal cavity of the base housing, and at least one fluid pathway disposed within the internal cavity. The the fluid pathway defines a plurality of linear-parallel cooling channels separated by corresponding plurality of linear-parallel cooling fins, a fluid supply channel, and a fluid return channel. A cooling fluid is able to flow through the fluid pathway by passing through the fluid supply channel, through the plurality of linear-parallel cooling channels, and back through the fluid return channel to cool the support pedestal device. In another form, the fluid pathway is formed integral with the base insert. In yet another form, the fluid pathway is formed in the base housing. In still another form, a first fluid pathway is formed in the base insert and a second fluid pathway is formed in the base housing.

In another form, a support pedestal device for an electrostatic chuck includes a plurality of linear-parallel cooling channels separated by corresponding plurality of linear-parallel cooling fins, a fluid supply channel, and a fluid return channel. A cooling fluid flows through the fluid supply channel, through the plurality of linear-parallel cooling channels, and back through the fluid return channel to cool the support pedestal device.

In yet another form, a method of manufacturing a support pedestal device is provided. The method includes: providing a base housing and a base insert; forming a plurality of linear fins in the base insert to define a plurality of linear cooling channels, wherein the plurality of linear cooling channels extend only in one direction and are in fluid communication with one another; and bonding the base insert to the base housing.

In another form of the present disclosure, a method of improving thermal conductivity and reducing thermal mass of a wafer support pedestal is provided. The method in one form includes: directing a cooling fluid through a fluid supply channel to a central portion of the wafer support pedestal; directing the cooling fluid outward radially; directing the cooling fluid bi-circumferentially; directing the cooling fluid through linear-parallel cooling channels; directing the cooling fluid bi-circumferentially; and directing the cooing fluid inward radially through a fluid return channel to the central portion of the wafer support pedestal. In another form, supply and return ports can be located around a periphery of the support pedestal device for directing cooling fluid.

Document US 2003/0159307 A1 discloses a substrate processing apparatus comprising a substrate holder thermally coupled to a cooling/heating system including a heat exchanger.

Further aspects of the present disclosure will be in part apparent and in part pointed out below. It should be understood that various aspects of the disclosure may be implemented individually or in combination with one another. It should also be understood that the detailed description and drawings, while indicating certain exemplary forms of the present disclosure, are intended for purposes of illustration only and should not be construed as limiting the scope of the disclosure.

### DRAWINGS

In order that the disclosure may be well understood, there will now be described various forms thereof, given by way of example, reference being made to the accompanying drawings, in which:
FIG. 1 is a schematic view of a prior art wafer support assembly;
FIG. 2 is a top view of a support pedestal device constructed in accordance with principles of the present disclosure;
FIG. 3 is a cross-sectional view of a support pedestal device taken along line 3-3 of FIG. 2, wherein electrode feedthroughs and securing members therefor are removed for clarity;
FIG. 4 is an enlarged view of detail A of the support pedestal device of FIG. 3;
FIG. 5 is a cross-sectional view of a base housing constructed according to the teachings of the present disclosure;
FIG. 6 is a perspective view of a base insert of a support pedestal device constructed in accordance with principles of the present disclosure;
FIG. 7 is a top view of a base insert of FIG. 6;
FIG. 8 is a cross-sectional view of the base insert, taken along line 8-8 of FIG. 7;
FIG. 9 is an enlarged view of Detail B of the base insert of FIG. 8;
FIG. 10 is another top view of a support pedestal device constructed in accordance with the principles of the present disclosure;
FIG. 11 is a cross-sectional view of the support pedestal device taken along line 11-11 of FIG. 10;
FIG. 12 is a cross-sectional view of the support pedestal device taken along line 12-12 of FIG. 10;
FIG. 13 is a flow diagram of a method of manufacturing a support pedestal device in accordance with the principles of the present disclosure;
FIGS. 14A to 14C show a step of forming recesses through a base insert in accordance with the principles of the present disclosure, wherein FIG. 14A is a top view of the base insert, FIG. 14B is a cross-sectional view of the base insert, and FIG. 14C is an enlarged view of portion D of FIG. 14B;
FIGS. 15 to 17 show a step of forming a fluid supply channel and a fluid return channel in a base insert in accordance with the principles of the present disclosure, wherein FIG. 15 is a top view of the base insert, FIG. 16 is a cross-sectional view of the base insert taken along line 6-6, and FIG. 17 is a cross-sectional view of the base insert taken along line 7-7;
FIGS. 18A and 18B show a step of forming a plurality of fins to form a plurality of cooling channels in a base insert in accordance with the principles of the present disclosure, wherein FIG. 18A is a top view of the base insert, and FIG. 18B is a cross-sectional view of the base insert taken along line 8-8 of FIG. 18A;
FIGS. 19A to 19C show a step of securing a plurality of feed-through spacers in the recesses of the base insert in accordance with the principles of the present disclosure, wherein FIG. 19A is a top view of the base insert, FIG. 19B is a cross-sectional view of the base insert taken along line 9-9 of FIG. 19A, and FIG. 19C is an enlarged view of portion E of FIG. 19B;
FIG. 20 shows a step of applying a space filler material in the cooling channels, the fluid supply channel, and the fluid return channel of the base insert in accordance with the principles of the present disclosure;
FIGS. 21A to 21D show a step of bonding a base insert to the base housing in accordance with the principles of the present disclosure, wherein FIG. 21A is a top view of the base insert, FIG. 21B is a cross-sectional view of the base insert taken along line 10-10 of FIG. 21A, FIG. 21C is a cross-sectional view of the base insert taken along line 11-11 of FIG. 21A, and FIG. 21D is an enlarged view of portion F of FIG. 21C;
FIG. 22 is a flow diagram of a method of improving thermal conductivity and reducing thermal mass of a support pedestal device in accordance with the principles of the present disclosure;
FIG. 23 is a schematic view of an experimental setup deployed to determine thermal resistance improvements of a support pedestal device constructed in accordance with the teachings of the present disclosure as compared to a generic device;
FIG. 24 is a schematic diagram of a thermal circuit for determining a thermal resistance constant;
FIG. 25 is a table of data showing a change in temperature over a varied increase in heat load of a generic device compared to a support pedestal device of the present disclosure;
FIG. 26 is a chart of the data points provided by the table of FIG. 25;
FIG. 27 is an alternative form of a support pedestal device with cooling fins formed in a base housing and constructed in accordance with the teachings of the present disclosure;
FIG. 28 is another alternative form of a support pedestal device with cooling fins formed in both a base housing and a base insert and constructed in accordance with the teachings of the present disclosure; and
FIG. 29 is a partial cross-sectional view of yet another form of a housing and base of a pedestal device constructed in accordance with the teachings of the present disclosure.

The drawings described herein are for illustration purposes only and are not intended to limit the scope of the present disclosure in any way.

### DETAILED DESCRIPTION

The following description is merely exemplary in nature and is not intended to limit the present disclosure or the disclosure's applications or uses. For example, the following forms of the present disclosure are directed to support assemblies for chucks for use in semiconductor processing, and in some instances, electrostatic chucks. However, it should be understood that the support assemblies and systems provided herein may be employed in a variety of applications and are not limited to semiconductor processing applications.

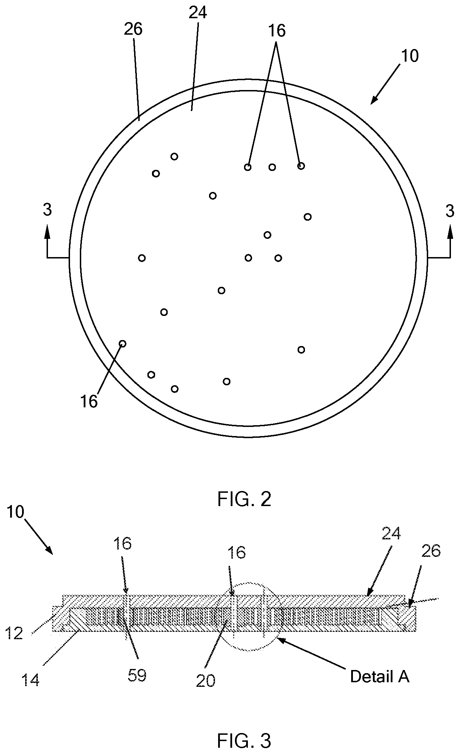

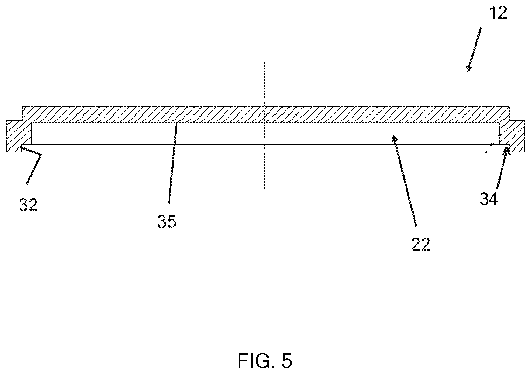

As shown in FIGS. 2 to 5, a support pedestal device 10 for an electrostatic chuck generally includes a base housing 12 and a base insert 14 disposed under the base housing 12. The base insert 14 may be a separate component from the base housing 12 or may be integrally formed with the base housing 12. The support pedestal device 10 defines a plurality of feed-through holes 16 through both the base housing 12 and the base insert 14 for receiving electrode feed-throughs (not shown). A plurality of feed-through spacers 20 are provided between the base housing 12 and the base insert 14 and define through holes 59 aligned with the feed-through holes 16 of the base housing 12 and the base insert 14. The support pedestal device 10 is adapted to be mounted under a wafer support device, such as an electrostatic chuck. The base housing 12 includes a main area 24 and a peripheral area 26 surrounding the main area 24. The main area 24 serves as a processing area. The support pedestal device 10 includes improved cooling features for controlling the temperature of the wafer support device and the wafer thereon, which will be described in more detail below.

The base housing 12 defines an internal cavity 22 for receiving the base insert 14 therein. The main area 24 defines the feed-through holes 16. The peripheral area 26 defines a plurality of mounting holes 30 through which screws (not shown) are inserted to mount the base housing 12 to the base insert 14. The main area 24 is raised from the peripheral area 26. The internal cavity 22 is defined by an inner side surface 32 of the base housing 12 and an upper surface 35. At least one positioning recess 34 is recessed from the inner side surface 32 of the base housing 12 in one form of the present disclosure.

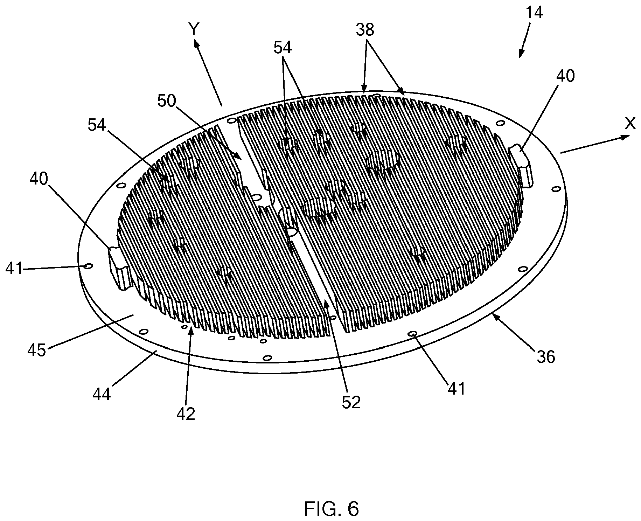

Referring to FIGS. 6 through 9, the base insert 14 includes a plate body 36, a plurality of linear fins 38 extending upwardly from the plate body 36, and at least one positioning flange 40. While two positioning flanges 40 are shown, it is understood that only one positioning flange 40 may be employed for mating with the positioning recess 34 of the base housing 12. The plate body 36 has an outer side face 44 that abuts an inner side surface 32 of the internal cavity 22 of the base housing 12. The plurality of linear fins 38 have a plurality of upper surfaces 46 that abut or are near the upper surface 35 of the internal cavity 22 when the base insert 14 is bonded to the base housing 12. A plurality of mounting holes 41 may be formed in the peripheral portion 45 of the base plate 14 and aligned with the mounting holes 30 of the base housing 12.

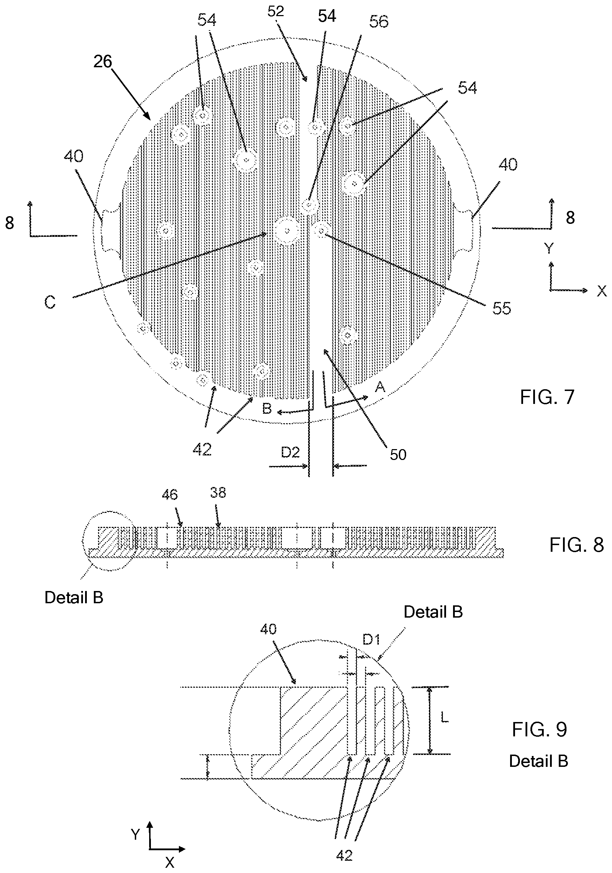

In one form, the plurality of linear fins 38 are parallel to each other and spaced at a first distance D1 (FIG. 9) in a first direction X. Accordingly, the term "linear-parallel" shall be construed to mean that the features are substantially geometrically linear and are spaced from each other in a perpendicular direction, or the linear features run parallel to each other. The plurality of linear fins 38 extend in a second direction Y to form a plurality of linear cooling channels 42 between adjacent linear fins 38. The plurality of linear cooling channels 42 extend in the second direction Y and are separated by the corresponding plurality of linear cooling fins 38. At least four linear fins are spaced at a second distance D2 larger than the first distance D1 to define a fluid supply channel 50 and a fluid return channel 52.

The base insert 14 further defines a plurality of recesses 54 which may be of the same size or different sizes. At least one of the recesses 54 is formed in the fluid supply channel 50 to define an inlet 55. At least one of the recesses 54 is formed in the fluid return channel 52 to define an outlet 56. It is shown in FIG. 7 that one recess 54 is formed in the fluid supply channel 50 to form one inlet 55 and two recesses 54 are formed in the fluid return channel 52 to form two outlets 56 to facilitate exit of the circulated cooling fluid from the pedestal support device 10. In another form, the inlet 55 and the outlet 56 may be formed around the peripheral area 26, or in other locations throughout the insert 14 while remaining within the scope of the present disclosure.

Referring to FIG. 9, the plurality of cooling channels 42 in one form define the same rectangular cross-sectional area. The height L of the linear fins 38 is larger than the distance D1 between adjacent fins 38 such that the cooling channels 42 each have an aspect ratio (L: D1) of about 10:1 in one form of the present disclosure. It should be understood that the number and size of fins 38 and cooling channels 42 may be varied according to cooling requirements of the application, and thus the various forms illustrated herein should not be construed as limiting the scope of the present disclosure. For example, the direction/orientation of the fins 38 may be such that they are not necessarily parallel to one another and may be at different angles with respect to adjacent fins 38. Additionally, the spacing and geometry of the fins 38 may be configured in order to provide zones of different thermal conductivity across the support pedestal device 10. Further, the fins 38 may have a non-constant cross-sectional area or alternate shapes other than the rectangular configuration as illustrated herein. Such variations should be construed as falling within the scope of the present disclosure.

The fluid supply channel 50, the fluid return channel 52 and the cooling channels 42 jointly define a flow path to allow a cooling fluid to flow inside the support pedestal device 10. The cooling channels 42 and the fluid supply channel 50 and the fluid return channel 52 are internal to the support pedestal device 10. The cooling fluid may come from a universal refrigerant source that also supplies the cooling fluid to other tools and chambers in the wafer processing system (not shown). The cooling fluid may be water or fluid phase change media to improve heat transfer and cooling efficiencies and responsiveness.

More specifically, the fluid supply channel 50 extends radially from a central portion C of the base insert 14. The fluid enters the fluid supply channel 50 through the inlet 55, is directed radially and outward in the fluid return channel 52, is directed bi-circumferentially (i.e., in opposite circumferential directions A and B) away from the fluid return channel 52 along the periphery of the base insert 14. Part of the cooling fluid enters the linear cooling channels 42 and flow in the second direction Y as the fluid is directed bi-circumferentially away from the fluid supply channel 50. After the fluid reaches the positioning flanges 40 that are diametrically opposed, the fluid is directed bi-circumferentially toward the fluid return channel 52. The two streams of fluid that flow bi-circumferentially from the fluid supply channel 50 and the plurality of streams flowing through the plurality of linear cooling channels 42 are merged at the fluid return channel 52 and then directed radially and inwardly in the fluid return channel 52 towards the central portion C of the base insert 14 and exist the support pedestal device 10 through the outlets 56.

The present disclosure provides various support pedestal devices and methods of operation with improved thermal management and cooling to maintain a more uniform temperature condition at a processing surface, particularly for an electrostatic chuck. Generally, increasing fluid flow rate in addition to the internal flow configuration as illustrated herein allows for the reduction of inlet to outlet temperature rise of a cooling fluid. The increased flow rate can accommodate a loss in pressure resulting from the presence of the cooling fins. The support pedestal device 10 allows for increased convection as compared to a generic wafer support device with increased surface area. The support pedestal device 10 grooves between the fins 38 are formed by the removal of material in one form of the present disclosure, for example a machining operation. This allows for more responsiveness to heat load with a reduced thermal mass. Flow impedance is also reduced while reducing back pressure according to the geometries illustrated herein and an increased fluid flow rate.

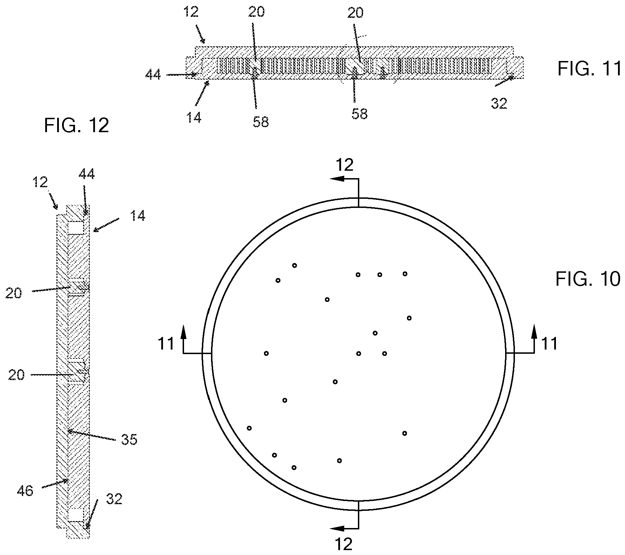

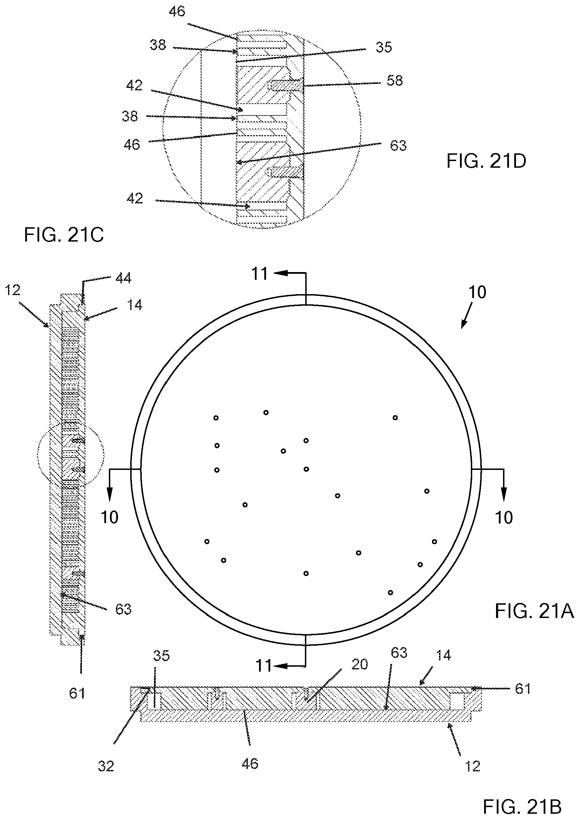

Referring to FIGS. 10 to 12, the base housing 12 may be brazed to the base insert 14 along the interface between the outer side face 44 of the plate body 36 of the base insert 14 and inner side surface 32 of the base housing 12, and along the interface between the upper surfaces 46 of the linear fins 38 and the upper surface 35 of the internal cavity 22 of the base housing 12, which will be described in more detail below in connection with FIGS. 21A to 21D.

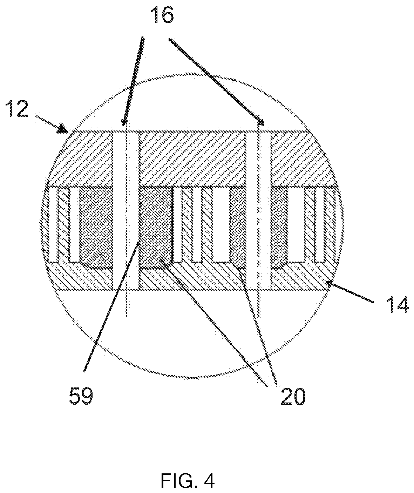

The plurality of feed-through spacers 20 are disposed in the recesses 54 to mount a plurality of electrode feed-throughs (not shown). The feed-through spacers 20 may be made of an Aluminum material and are mounted to the base plate 36 of the base insert 14 by screws 58. The feed-through spacers 20 may each include a through hole 59 (shown in FIGS. 3 and 4) coaxially aligned with the feed-through holes 16 formed in the support pedestal device 10 so that the electrode feed-throughs (not shown) may be inserted. In other words, the feed-through spacers 20 each define a through hole 59 for receiving an electrode fee-through, and a screw hole for receiving the screw 58.

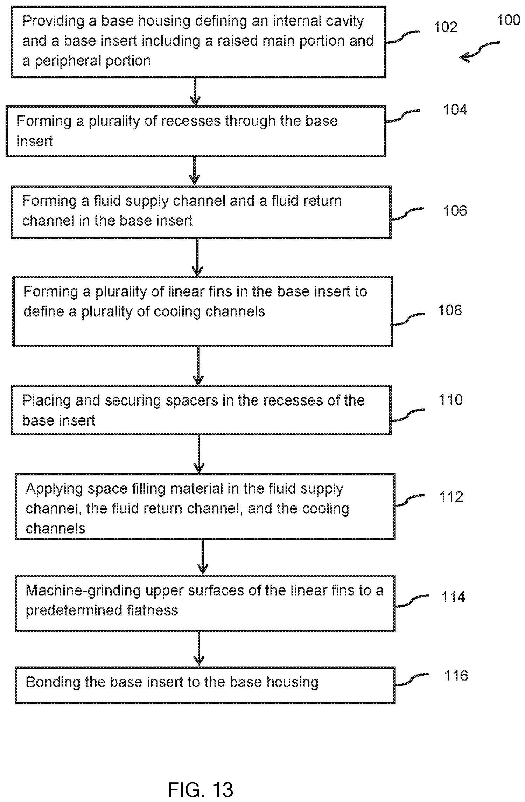

Referring to FIG. 13, a method 100 of manufacturing a support pedestal device 10 starts with providing a base housing 12 defining an internal cavity 22 and a base insert 14 including a raised main portion 43 and a peripheral portion 45 in step 102. The base housing 12 and the base insert 14 may be formed integrally by investment casting or additive manufacturing. The peripheral portion 45 of the base insert 14 surrounds the raised main portion 43.

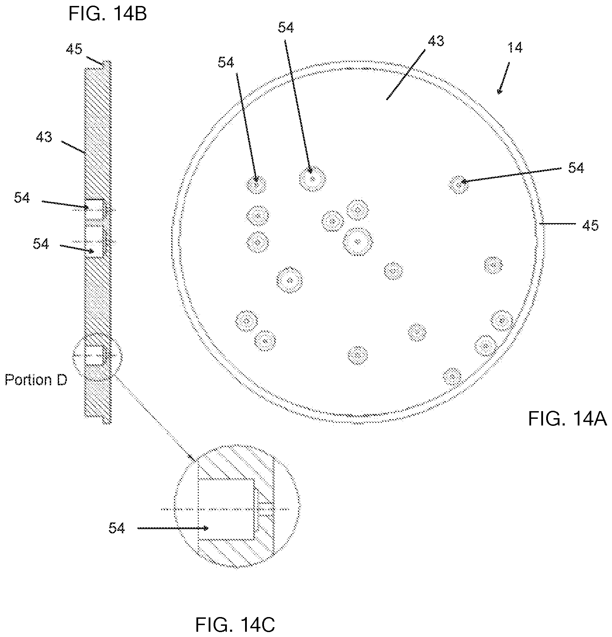

Next, with reference also to FIGS. 14A to 14C, the base insert 14 is machined in one form to form a plurality of recesses 54 in step 104. The recesses 54 extend through the raised main portion 43 of the base insert 14 and may be of equal size or varied size.

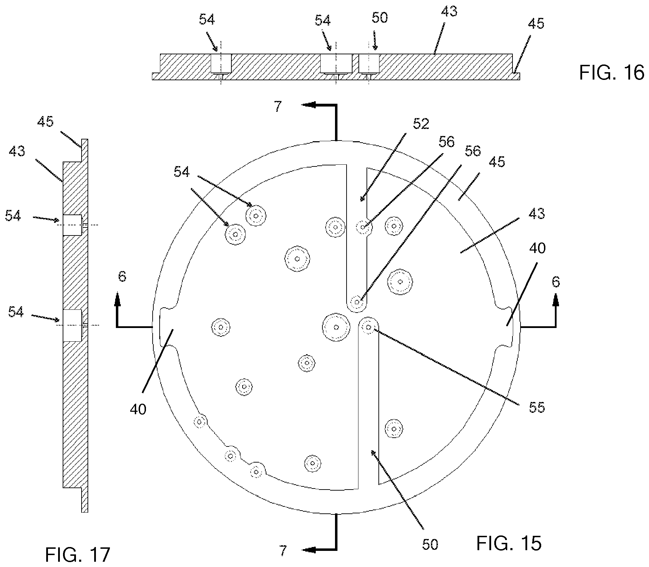

Next, the base insert 14 is machined to form a fluid supply channel 50 and a fluid return channel 52 in step 106. As shown in FIGS. 15 through 17, the fluid supply channel 50 and the fluid return channel 52 are in the form of two straight slots formed adjacent to the central portion C of the base insert 14, offset along a first direction X (i.e., a radial direction), and extend along a second direction Y. The fluid supply channel 50 and the fluid return channel 52 are parallel and in fluid communication with at least one of the recesses 54. The recesses 54 in the fluid supply channel 50 and the fluid return channel 52 function as an inlet 55 and an outlet 56 of the flow path, respectively. Optionally, a peripheral edge of the raised main portion 24 is machined to enlarge the peripheral portion 45 such that a pair of radial flanges 40 are formed diametrically of the base insert 14, along the first direction X. While not shown in FIG. 14A, it is understood that mounting holes 41 (shown in FIG. 9A) can be formed in the peripheral portion 45.

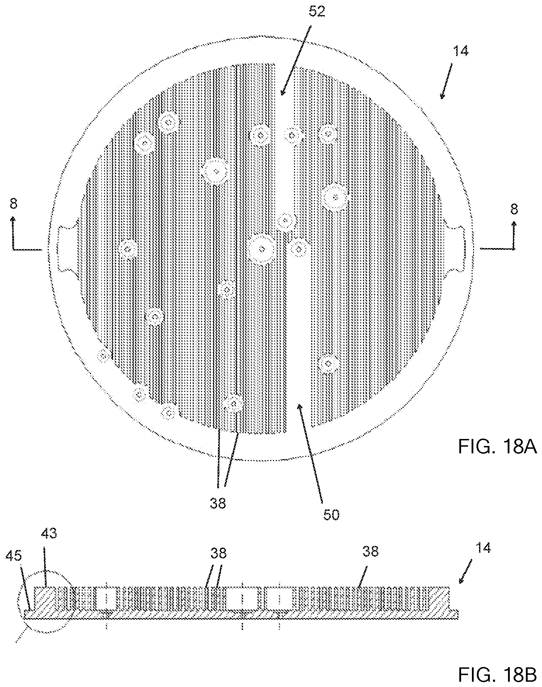

Next, as shown in FIGS. 18A and 18B, the raised main portion 43 of the base insert 14 is machined to form a plurality of linear fins 38 parallel to the fluid supply channel 50 and the fluid return channel 52 in step 108. The linear fins 38 are parallel to one another and extend along the second direction Y and spaced apart at a predetermined distance along the first direction X. As such, a plurality of cooling channels 42 are defined between adjacent linear fins 38 and separated by the linear fins 38.

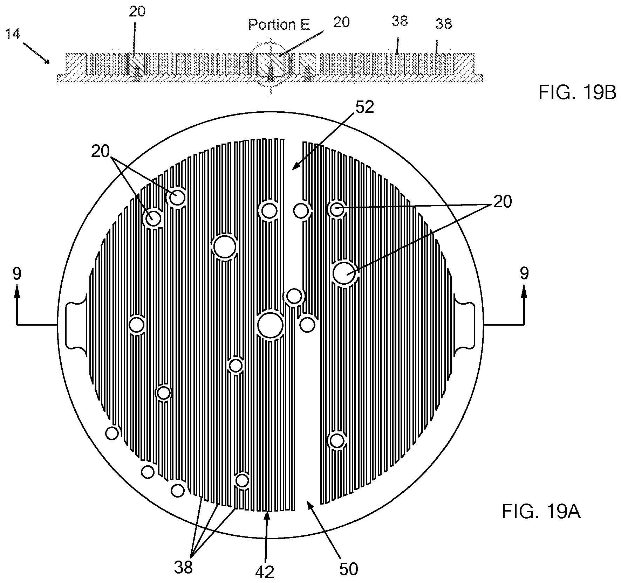

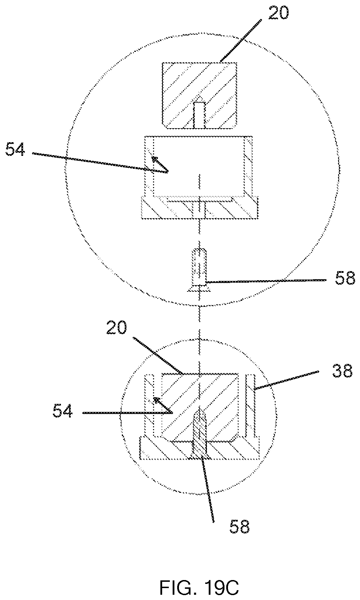

As shown in FIGS. 19A to 19C, a plurality of feed-through spacers 20 are disposed in the recesses 54 and secured to the base insert 14 in step 110. The plurality of feed-through spacers 20 correspond to the plurality of recesses 54 and may be secured to the base insert 14 by screws 58. The feed-through spacers 20 include threaded holes to be inserted by the screws 58. The feed-through spacers 20 also define through holes 59 (shown in FIGS. 3 and 4) aligned with the through holes 16 of the support pedestal device 10 to allow the electrode feed throughs to pass through. The feed-through spacers 20 also function to protect the electrode feed-throughs and prevent the cooling fluid from contacting the electrode feed-throughs.

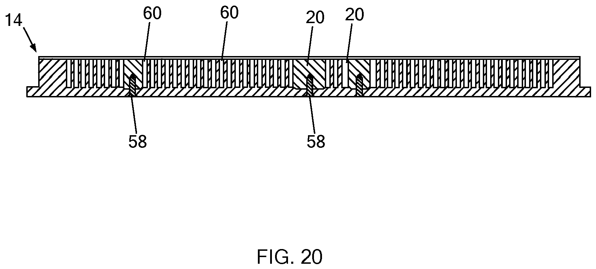

Next, a space filler material 60 is filled in the cooling channels 42, the fluid supply channel 50 and the fluid return channel 52 in step 112, followed by machine-grinding the upper surfaces 46 of the linear fins 38 in step 114. As shown in FIG. 20, the space filler material 60 is filled in any open space in the base insert 14, including the cooling channels 42, the fluid supply channel 50, the fluid return channel 52, and a part of the recesses 54 not occupied by the feed-through spacers 20. The space filler material 60 prevents dust and residues generated in the subsequent machine-grinding step from entering the open space in the base insert 14. The space filling material 60 may be sacrificial filling materials, such as paraffin wax. Any other material suitable for this purpose may be used. The space filler material 60 can be later removed by heat or mechanical means, among others, after the base insert 14 is bonded to the base housing 12. The machine-grinding step ensures flatness of the upper surfaces 46 of the linear fins 38 to ensure improved bonding of the upper surfaces 46 of the linear fins 38 to the upper surface 35 of the internal cavity 22 of the base housing 12.

Finally, the base insert 14 with the feed-through spacers 20 is bonded to the base housing 12 along the interfaces between the base housing 12 and the base insert 14 in step 116. As shown in FIGS. 21A to 21D, when the base insert 14 is inserted in the internal cavity 22 of the base housing 12, the outer side face 44 of the plate body 36 of the base insert 14 abuts an inner side surface 32 of the internal cavity 22 of the base housing 12 to define a first interface 61 therebetween, and the upper surfaces 46 of the linear fins 38 abut the upper surface 35 of the internal cavity 22 of the base housing 12 to define a second interface 63 therebetween (shown in FIGS. 21B to 21D). The base housing 12 may be brazed to the base insert 14 along the first and second interfaces 61 and 63. The bonding can be achieved by placing, heating and curing a brazing material on the upper surfaces 46 of the plurality of linear fins 38 and the outer side face 44 of the plate body 36 of the base insert 14.

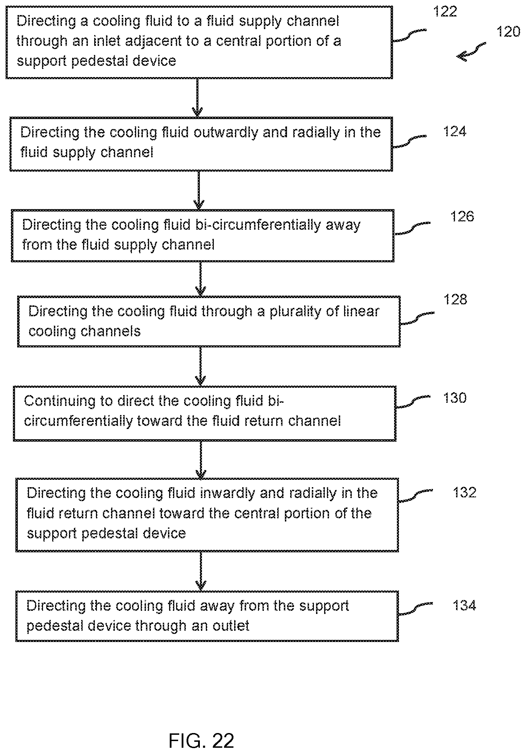

Referring to FIG. 22, a method 120 of improving thermal conductivity and reducing thermal mass of a support pedestal device 10 starts with directing a cooling fluid to a fluid supply channel 50 through an inlet 55 adjacent to a central portion of the support pedestal device 10 in step 122. Next, the cooling fluid is directed outwardly and radially in the fluid supply channel 50 in step 124. Then, the cooling fluid is directed bi-circumferentially away from the fluid supply channel 50 in step 126, followed by directing the cooling fluid through the plurality of linear and parallel cooling channels 42 in step 128. The cooling fluid continues to be directed bi-circumferentially toward the fluid return channel 52 in step 130. The cooling fluid is then directed inwardly and radially in the fluid return channel 52 to the central portion C of the support pedestal device 10 in step 132. Finally, the cooling fluid is directed away from the support pedestal device 10 through an outlet 56. The cooling fluid may be water, or may include fluid-phase-change media to improve heat transfer and cooling efficiency and responsiveness. Any cooling fluid may be used without departing from the scope of the present disclosure.

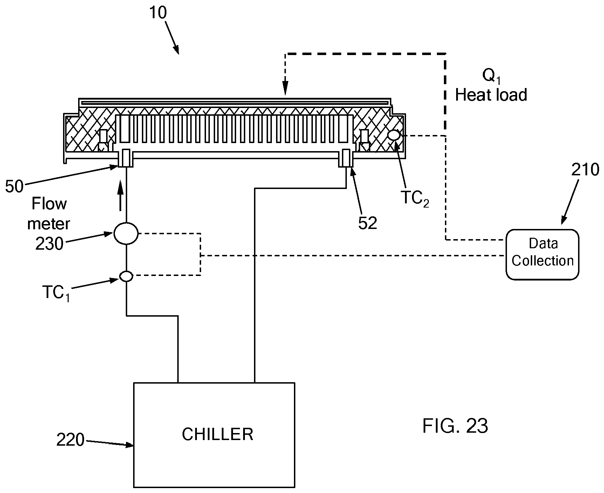

Referring to FIG. 23 to FIG. 26, an experiment was performed to determine the thermal dissipation benefits associated with a support pedestal device of the present disclosure. A support pedestal device 10 was deployed and exposed to a heat load Q1. A pair of thermal couples TC₁ and TC₂ were positioned as shown to measure temperature increase of the cooling fluid provided by chiller 220. TC₁ was positioned before the inlet fluid supply channel 50 as shown. A flow meter 230 was also positioned in between chiller 220 which supplies cooling fluid and supply channel 50. As the fluid passes through device 10 and into the flow channels 42 formed by the linear fins 38, the fluid absorbs the heat from heat load Q1. The heated fluid returns to the chiller 220 through return channel 52 where another thermocouple TC₂ was positioned. Both thermal couples TC₁ and TC₂ along with the flow meter 230 were coupled to a data collection device 210 to collect the temperature information and determine improved performance. A similar test was performed using a generic pedestal device so a comparison could be made.

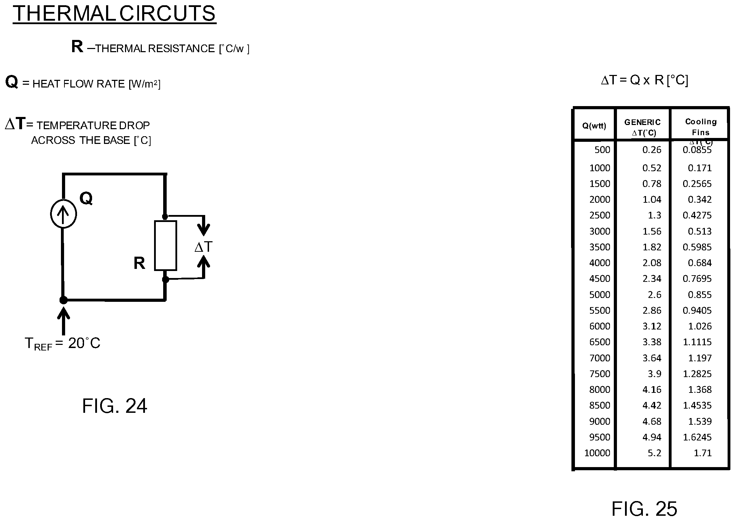

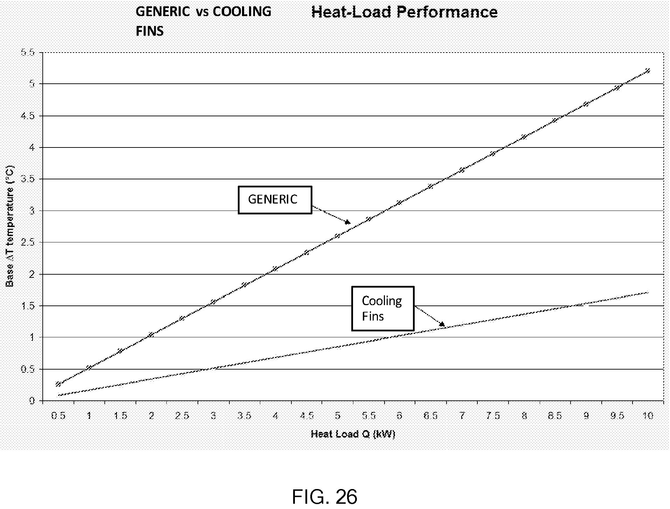

The thermal circuit shown in FIG. 24 illustrates how a thermal resistance constant R can be determined by knowing the heat flow rate Q and measuring the temperature drop across the device 10. The table of FIG. 25 and the chart of FIG. 26 shows a comparison of a device 10 having cooling fins according to the present disclosure and that of a generic pedestal device. Measuring the temperature change of the devices over a different heat load flow rates Q, the R value for each type of device can be calculated. According to the experiment, a generic pedestal device showed a thermal resistance of 0.000520°C/W whereas the improved pedestal device having cooling fins according to the present disclosure resulted in a thermal resistance of 0.000171°C/W. Thus, a 30% increase in thermal transfer was obtained using the pedestal device 10 according to the present disclosure.

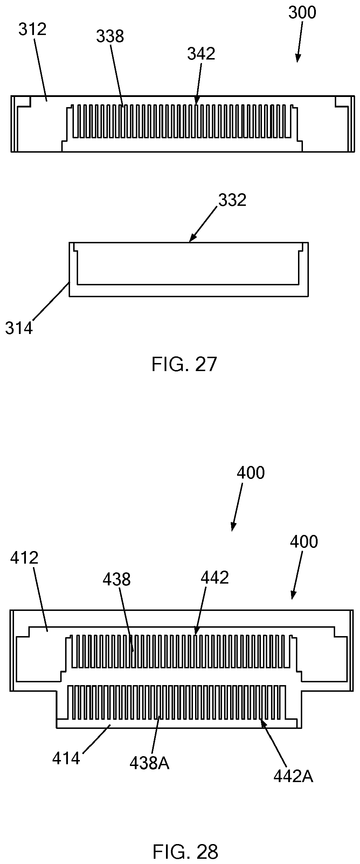

Referring to FIGS. 27-28, additional forms of the pedestal support device according to the present disclosure are shown with the fins formed in the housing instead of the insert (FIG. 27), or fins formed in both the housing and the insert (FIG. 28). In FIG. 27, an alternative support pedestal device 300 includes a base housing 312 for receiving a base insert 314. The base insert 314 defines an internal cavity 322. Base housing 312 includes linear fins 338 forming cooling channels 342 along with the supply and return channels (previously shown). The cooling channels 342 are adapted to receive a cooling fluid for thermal management of a processing surface above the base housing 312. With the fins 338 being formed in the housing 312, and a brazed interface as set forth above, the brazed interface is moved further away from a top surface of the housing (i.e. to the bottom portion of the fins 338 where they meet the inside of the insert 314) so as to move a potential source of thermal resistance.

In yet another form, as shown in FIG. 28, a support pedestal device 400 is shown. In this variation, a base housing 412 is provided having cooling fins 438 forming cooling channels 442. The base housing 412 is adapted to receive a base insert 414. Base insert 414 also includes cooling fins 438A forming flow channels 442A. When combined with base housing 412, the cooling fins 438 and 438A form cooling channels 442 and 442A to allow for cooling fluid to pass through device 400 as previously described.

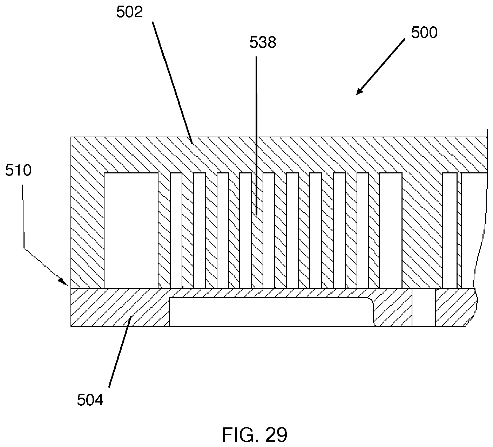

Referring to FIG. 29, another form of a base housing and base insert are illustrated as support pedestal device 500. The support pedestal device 500 includes a base housing 502 having the fins 538 as previously described, while a base insert 504 does not include fins. In one form, the base housing 502 is brazed to the base insert 504 along a braze line 510, which moves this potential source of thermal resistance away from the top of the housing 502 as previously described. It should be understood that the term "insert" should not be construed to mean that that base must necessarily be inserted within a cavity of the base housing as previously illustrated and may include the configuration as shown in this FIG. 29 with a planar interface. Accordingly, the housing and base may be planar or otherwise flush with each other, or be inserted one inside the other, or have locking features to secure these two components together while remaining within the scope of the present disclosure.

In still another form, a two-phase fluid may be provided to flow through the cooling channels, and a pressure of the two-phase fluid is controlled such that the two-phase fluid provides further heating or thermal conductivity properties to the support pedestal devices of the present disclosure. This system is described in greater detail, for example, in U.S. Patent Nos. 7,178,353 and 7,415,835 and also in published U.S. application No. 20100076611, the contents of which are incorporated herein by reference in their entirety. Generally, in these systems, pressurized refrigerant is provided as a condensed liquid and also in a gaseous state. The condensed liquid is expanded to a vaporous mix, and the gaseous refrigerant is added to reach a target temperature determined by its pressure. Temperature corrections can thus be made very rapidly by gas pressure adjustments.

It should be noted that the disclosure is not limited to the embodiments described and illustrated as examples. A large variety of modifications have been described and more are part of the knowledge of the person skilled in the art. These and further modifications as well as any replacement by technical equivalents may be added to the description and figures, without leaving the scope of the protection of the disclosure and of the present application. The invention is defined by the appended claims.

## Claims

1. A support pedestal device (10) for an electrostatic chuck comprising: a base housing (12) defining an internal cavity (22); a base insert (14) disposed proximate the internal cavity (22) of the base housing (12); and at least one fluid pathway disposed within the internal cavity (22), the fluid pathway defining: a plurality of cooling channels (42); a fluid supply channel (50); and a fluid return channel (52),wherein a cooling fluid is able to flow through the fluid pathway by passing through the fluid supply channel (50), through the plurality of cooling channels (42), and back through the fluid return channel (52) to cool the support pedestal device (10),
**characterized in that** the plurality of cooling channels (42) are linear-parallel cooling channels separated by a corresponding plurality of linear-parallel cooling fins (38).

2. The support pedestal device (10) according to Claim 1, wherein the linear-parallel cooling fins (38) are a part of the base insert (14) or a part of the base housing (12).

3. The support pedestal device (10) according to Claim 1, wherein a first fluid pathway is formed in the base insert (14) and a second fluid pathway is formed in the base housing (12), wherein each fluid pathway defines a plurality of linear-parallel cooling channels (42) separated by a corresponding plurality of linear-parallel cooling fins (38), a fluid supply channel (50), and a fluid return channel (52), wherein the linear-parallel cooling fins (38) are a part of the base housing (12) and the base insert (14).

4. The support pedestal device (10) according to Claim 1, wherein the base housing (12) and the base insert (14) are separate components.

5. The support pedestal device (10) according to Claim 1 further comprising a plurality of electrode feed-throughs extending through the base housing (12) and the base insert (14).

6. The support pedestal device (10) according to Claim 5 further comprising a plurality of spacers (20) disposed within recesses (54) formed in either the base housing (12) or the base insert (14), wherein the electrode feed-throughs extend through the spacers (20).

7. The support pedestal device (10) according to Claim 1, wherein the fluid supply channel (50) extends radially from a central portion (C), in a direction parallel to the cooling channels (42), and then bi-circumferentially around an outer periphery of the fluid pathway.

8. The support pedestal device (10) according to Claim 1, wherein the fluid return channel (52) extends bi-circumferentially and then radially to a central portion (C), in a direction parallel to the cooling channels (42) of the fluid pathway.

9. The support pedestal device (10) according to Claim 1, wherein a fluid inlet (55) and a fluid outlet (56) are formed around a peripheral area (26) of the support pedestal device

10. The support pedestal device (10) according to Claim 1, wherein the base insert (14) comprises a lower radial flange (40) defining an outer face that abuts an inner side surface of the internal cavity (22) of the base housing (12).

11. The support pedestal device (10) according to Claim 1, wherein the plurality of cooling channels (42) define the same cross-sectional area.

12. The support pedestal device (10) according to Claim 11, wherein the cooling channels (42) define an aspect ratio of about 10:1.

13. The support pedestal device (10) according to Claim 1, wherein the device defines a thermal resistance of 0.000171°C/W or less.

14. The support pedestal device (10) according to Claim 1, wherein an interface between the base housing (12) and the base insert (14) is planar.

15. The support pedestal device (10) according to Claim 1, wherein the linear-parallel cooling fins (38) define a spacing and geometry to provide zones of different thermal conductivity across the support pedestal device (10).

## Patentansprüche

1. Tragsockelvorrichtung (10) für einen elektrostatischen Chuck, umfassend: ein Basisgehäuse (12), das einen Innenhohlraum (22) definiert; einen Basiseinsatz (14), der nahe des Innenhohlraums (22) des Basisgehäuses (12) angeordnet ist; und mindestens einen Fluidweg, der innerhalb des Innenhohlraums (22) angeordnet ist, wobei der Fluidweg definiert: eine Vielzahl von Kühlkanälen (42); einen Fluidzuführkanal (50); und einen Fluidrückführkanal (52), wobei ein Kühlfluid durch den Fluidweg fließen kann, indem es durch den Fluidzuführkanal (50), durch die Vielzahl von Kühlkanälen (42) und zurück durch den Fluidrückführkanal (52) läuft, um die Tragsockelvorrichtung (10) zu kühlen,
**dadurch gekennzeichnet, dass** die Vielzahl von Kühlkanälen (42) geradlinig parallele Kühlkanäle sind, die durch eine entsprechende Vielzahl von geradlinig parallelen Kühlrippen (38) getrennt sind.

2. Tragsockelvorrichtung (10) nach Anspruch 1, wobei die geradlinig parallelen Kühlrippen (38) ein Teil des Basiseinsatzes (14) oder ein Teil des Basisgehäuses (12) sind.

3. Tragsockelvorrichtung (10) nach Anspruch 1, wobei ein erster Fluidweg im Basiseinsatz (14) gebildet ist, und ein zweiter Fluidweg im Basisgehäuse (12) gebildet ist, wobei jeder Fluidweg eine Vielzahl von geradlinig parallelen Kühlkanälen (42), die durch eine entsprechende Vielzahl von geradlinig parallelen Kühlrippen (38) getrennt sind, einen Fluidzuführkanal (50) und einen Fluidrückführkanal (52) definiert, wobei die geradlinig parallelen Kühlrippen (38) ein Teil des Basisgehäuses (12) und des Basiseinsatzes (14) sind.

4. Tragsockelvorrichtung (10) nach Anspruch 1, wobei das Basisgehäuse (12) und der Basiseinsatz (14) getrennte Komponenten sind.

5. Tragsockelvorrichtung (10) nach Anspruch 1, weiter eine Vielzahl von Elektrodendurchführungen umfassend, die sich durch das Basisgehäuse (12) und den Basiseinsatz (14) erstrecken.

6. Tragsockelvorrichtung (10) nach Anspruch 5, weiter eine Vielzahl von Abstandshaltern (20) umfassend, die innerhalb von Vertiefungen (54) angeordnet sind, welche entweder im Basisgehäuse (12) oder dem Basiseinsatz (14) gebildet sind, wobei sich die Elektrodendurchführungen durch die Abstandshalter (20) erstrecken.

7. Tragsockelvorrichtung (10) nach Anspruch 1, wobei sich der Fluidzuführkanal (50) radial von einem zentralen Abschnitt (C) in einer Richtung parallel zu den Kühlkanälen (42) und dann in zwei Umfangsrichtungen um einen äußeren Rand des Fluidweges herum erstreckt.

8. Tragsockelvorrichtung (10) nach Anspruch 1, wobei sich der Fluidrückführkanal (52) in zwei Umfangsrichtungen und dann radial zu einem zentralen Abschnitt (C) in einer Richtung parallel zu den Kühlkanälen (42) des Fluidweges erstreckt.

9. Tragsockelvorrichtung (10) nach Anspruch 1, wobei ein Fluideinlass (55) und ein Fluidauslass (56) um einen Randbereich (26) der Tragsockelvorrichtung herum gebildet sind.

10. Tragsockelvorrichtung (10) nach Anspruch 1, wobei der Basiseinsatz (14) einen unteren radialen Flansch (40) umfasst, der eine äußere Fläche definiert, die an einer inneren Seitenfläche des Innenhohlraums (22) des Basisgehäuses (12) anliegt.

11. Tragsockelvorrichtung (10) nach Anspruch 1, wobei die Vielzahl von Kühlkanälen (42) dieselbe Querschnittsfläche definieren.

12. Tragsockelvorrichtung (10) nach Anspruch 11, wobei die Kühlkanäle (42) ein Seitenverhältnis von etwa 10:1 definieren.

13. Tragsockelvorrichtung (10) nach Anspruch 1, wobei die Vorrichtung einen Wärmewiderstand von 0,000171 °C/W oder weniger definiert.

14. Tragsockelvorrichtung (10) nach Anspruch 1, wobei eine Schnittstelle zwischen dem Basisgehäuse (12) und dem Basiseinsatz (14) plan ist.

15. Tragsockelvorrichtung (10) nach Anspruch 1, wobei die geradlinig parallelen Kühlrippen (38) einen Abstand und eine Geometrie so definieren, dass über die Tragsockelvorrichtung (10) hinweg Zonen von unterschiedlicher Wärmeleitfähigkeit bereitgestellt werden.

## Revendications

1. Dispositif de socle de support (10) pour un mandrin électrostatique comprenant : un boîtier de base (12) définissant une cavité interne (22) ; un insert de base (14) disposé à proximité de la cavité interne (22) du boîtier de base (12) ; et au moins une voie de passage de fluide disposée dans la cavité interne (22), la voie de passage de fluide définissant : une pluralité de canaux de refroidissement (42) ; un canal d'alimentation en fluide (50) ; et un canal de retour de fluide (52), dans lequel un fluide de refroidissement peut s'écouler à travers la voie de passage de fluide en passant à travers le canal d'alimentation en fluide (50), à travers la pluralité de canaux de refroidissement (42), et en retour à travers le canal de retour de fluide (52) pour refroidir le dispositif de socle de support (10),
**caractérisé en ce que** la pluralité de canaux de refroidissement (42) sont des canaux de refroidissement linéaires-parallèles séparés par une pluralité correspondante d'ailettes de refroidissement linéaires-parallèles (38).

2. Dispositif de socle de support (10) selon la revendication 1, dans lequel les ailettes de refroidissement linéaires-parallèles (38) font partie de l'insert de base (14) ou font partie du boîtier de base (12).

3. Dispositif de socle de support (10) selon la revendication 1, dans lequel une première voie de passage de fluide est formée dans l'insert de base (14) et une deuxième voie de passage de fluide est formée dans le boîtier de base (12), dans lequel chaque voie de passage de fluide définit une pluralité de canaux de refroidissement linéaires-parallèles (42) séparés par une pluralité correspondante d'ailettes de refroidissement linéaires-parallèles (38), un canal d'alimentation en fluide (50) et un canal de retour de fluide (52), dans lequel les ailettes de refroidissement linéaires-parallèles (38) font partie du boîtier de base (12) et de l'insert de base (14).

4. Dispositif de socle de support (10) selon la revendication 1, dans lequel le boîtier de base (12) et l'insert de base (14) sont des composants séparés.

5. Dispositif de socle de support (10) selon la revendication 1, comprenant en outre une pluralité de traversées d'électrodes s'étendant à travers le boîtier de base (12) et l'insert de base (14).

6. Dispositif de socle de support (10) selon la revendication 5, comprenant en outre une pluralité d'espaceurs (20) disposés dans des évidements (54) formés soit dans le boîtier de base (12), soit dans l'insert de base (14), dans lequel les traversées d'électrodes s'étendent à travers les espaceurs (20).

7. Dispositif de socle de support (10) selon la revendication 1, dans lequel le canal d'alimentation en fluide (50) s'étend radialement à partir d'une partie centrale (C) dans une direction parallèle aux canaux de refroidissement (42), et ensuite de manière bi-circonférentielle autour d'une périphérie externe de la voie de passage de fluide.

8. Dispositif de socle de support (10) selon la revendication 1, dans lequel le canal de retour de fluide (52) s'étend de manière bi-circonférentielle et ensuite radialement vers une partie centrale (C), dans une direction parallèle aux canaux de refroidissement (42) de la voie de passage de fluide.

9. Dispositif de socle de support (10) selon la revendication 1, dans lequel une entrée de fluide (55) et une sortie de fluide (56) sont formées autour d'une zone périphérique (26) du dispositif de socle de support.

10. Dispositif de socle de support (10) selon la revendication 1, dans lequel l'insert de base (14) comprend une bride radiale inférieure (40) définissant une face externe qui vient en butée contre une surface latérale interne de la cavité interne (22) du boîtier de base (12).

11. Dispositif de socle de support (10) selon la revendication 1, dans lequel la pluralité de canaux de refroidissement (42) définissent la même surface de section transversale.

12. Dispositif de socle de support (10) selon la revendication 11, dans lequel les canaux de refroidissement (42) définissent un rapport d'aspect d'environ 10:1.

13. Dispositif de socle de support (10) selon la revendication 1, dans lequel le dispositif définit une résistance thermique inférieure ou égale à 0,000171°C/W.

14. Dispositif de socle de support (10) selon la revendication 1, dans lequel une interface entre le boîtier de base (12) et l'insert de base (14) est plane.

15. Dispositif de socle de support (10) selon la revendication 1, dans lequel les ailettes de refroidissement linéaires-parallèles (38) définissent un espacement et une géométrie pour fournir des zones de conductivité thermique différente à travers le dispositif de socle de support (10).
